# EUROPEAN PATENT SPECIFICATION

(11) **EP 4 203 084 B1**
(45) Date of publication and mention of the grant of the patent: **18.11.2026**
(21) Application number: 21217098.9
(22) Date of filing: 22.12.2021
(51) Int. Cl.: B41J 11/00, B82Y 20/00, H10K 71/13

(54) **METHOD FOR PREPARING A STACK OF DIELECTRIC LAYERS ON A SUBSTRATE**
VERFAHREN ZUR HERSTELLUNG EINES STAPELS DIELEKTRISCHER SCHICHTEN AUF EINEM SUBSTRAT
PROCÉDÉ DE PRÉPARATION D'UNE PILE DE COUCHES DIÉLECTRIQUES SUR UN SUBSTRAT

(43) Date of publication of application: 28.06.2023
(73) Proprietor: Baden-Württemberg Stiftung gGmbH, 70174 Stuttgart (DE)
(72) Inventor: ZHANG, Qiaoshuang, 76187 Karlsruhe (DE); LEMMER, Ulrich, 76228 Karlsruhe (DE); JIN, Qihao, 76187 Karlsruhe (DE)
(74) Representative: Qip Patent & Recht Dr. Kuehn & Partner mbB

(56) References cited:
- WO-A1-2011/003987
- WO-A2-2017/065641
- US-A1- 2018 056 671
- YAKOVLEV ALEKSANDR V. ET AL: "Inkjet printing of TiO2/AlOOH heterostructures for the formation of interference color images with high optical visibility", vol. 6, no. 1, 16 November 2016 (2016-11-16), XP055931674, Retrieved from the Internet <URL:http://www.nature.com/articles/srep37090> DOI: 10.1038/srep37090
- JIN QIHAO ET AL: "High Dynamic Range Smart Window Display by Surface Hydrophilization and Inkjet Printing", vol. 7, no. 5, 10 October 2021 (2021-10-10), DE, pages 2101026, XP055932137, ISSN: 2365-709X, Retrieved from the Internet <URL:https://onlinelibrary.wiley.com/doi/full-xml/10.1002/admt.202101026> DOI: 10.1002/admt.202101026

## Description

### FIELD OF THE INVENTION

The present invention relates to a method for preparing a stack of dielectric layers on a substrate.

### TECHNICAL BACKGROUND

One or more dielectric layers deposited on top of a surface of a substrate may serve various purposes. For example, dielectric layers may influence functionalities of an optical, electrical and/or mechanical device. Therein, the dielectric layer(s) may provide for specific physical characteristics, particularly specific optical characteristics, electrical characteristics, mechanical characteristics, etc. The physical characteristics are generally dependent on material characteristics of the dielectric, e.g. its optical refractive index, its optical absorption, its electrical conductivity, its density, its hardness, etc. Furthermore, the physical characteristics are generally also dependent on characteristics of the layer of dielectric material, e.g. a layer thickness, a layer homogeneity, surface characteristics of the layer, etc.

For example, the dielectric layer(s) may provide for specific optical characteristics of the coated substrate surface. In specific applications, a dielectric layer with a precisely predetermined thickness in the range of a fraction of wavelengths of visible light may cover the substrate surface, thereby changing reflection characteristics of the surface. In order to even further improve optical reflection or transmission characteristics of such dielectric layer coating, multiple dielectric layers may be deposited on top of each other, thereby forming a stack of dielectric layers. Due to the fact that optical characteristics, particularly optical reflectance and/or transmission, of such a dielectric layer stack significantly varies depending on the wavelengths of electromagnetic radiation impinging to such dielectric layer stack, the dielectric layer stack is often referred to as a one-dimensional photonic crystal (1DPC) or as a dielectric mirror.

Conventionally, dielectric layers may be prepared on a substrate using various deposition techniques. For example, PVD (physical vapor deposition) or CVD (chemical vapor deposition) techniques have been applied for depositing one or various dielectric layers having precisely defined layer thicknesses. More recently, dielectric layers are prepared by solution processing such as spin coating or doctor blading.

However, it has been found that conventional techniques for depositing one or more dielectric layers may suffer from various deficiencies. For example, such conventional techniques may allow preparing dielectric layers on top of entire surfaces of substrates, the substrates having limited lateral extensions. However, using such conventional techniques does generally not allow preparing dielectric layers having a lateral patterning, i.e. the dielectric layers having laterally neighboring areas of e.g. different layer thicknesses. In case such lateral patterning is required, additional measures have to be applied such as covering partial areas of the substrate surface with masks during a deposition procedure and/or subsequently removing dielectric material from an initially homogeneously deposited dielectric layer using for example lithographic patterning and etching. However, applying such additional measures generally significantly increases processing complexity. Furthermore, using such conventional techniques, it was generally difficult or even impossible to deposit dielectric layers along large surfaces. Particularly, it is generally a complex task to apply thin dielectric layers along large surface areas with the layers having a homogeneous layer thickness and/or a homogeneous layer quality. Furthermore, conventional techniques, especially those using solution-based processing, may suffer from excessively wasting parts of the dielectric material. Additionally, a layer quality or layer stack quality may be poor due to for example striations and comets being formed in the dielectric thin-film(s).

YAKOVLEV ALEKSANDR V . ET AL: "Inkjet printing of TiO2/A100H heterostructures for the formation of interference color images with high optical visibility", SCIENTIFIC REPORTS, vol. 6 , no. 1, 16 November 2016 (2016-11-16), XP055931674, DOI: 10.1038/srep37090 discloses heterostructures formed by inkjet printing.

WO 2011/003987 A1 discloses a dye sensitized solar cell with improved optical characteristics due to a 1-dimensional photonic crystal. US 2018/056671 A1 discloses a method and facility for coating a body with a formation of a structured surface.

WO 2017/065641 A2 discloses methods for color ink-jet printing.

### SUMMARY OF THE INVENTION AND OF EMBODIMENTS

There may be a need for an alternative method for preparing one or more dielectric layers on a substrate, the method overcoming at least one or some of the abovementioned deficiencies. Particularly, there may be a need for a method for preparing one or more dielectric layers on the substrate, the method allowing for generating dielectric layers with a lateral patterning and/or depositing dielectric layers on large surface areas, while being easily applicable with simple and/or readily available tools, at low cost, with high layer quality, with high reproducibility, with high reliability and/or other beneficial characteristics.

Such needs may be met with the method according to the independent claim. Advantageous embodiments are defined in the dependent claims as well as in the present specification and are visualized in the figures.

According to an aspect of the present invention, a method for preparing a stack of dielectric layers forming a one-dimensional photonic crystal on a substrate is proposed as described in claim 1.

Ideas underlying embodiments of the present invention may be interpreted as being based, inter alia, on the following observations and recognitions.

Briefly summarized and without limiting the scope of the invention, a basic idea underlying embodiments of the invention and associated possible advantages will be roughly described as follows:
While solution-based processes for generating dielectric layers are generally known, these processes typically apply a relatively large volume of liquid comprising dielectric constituents onto a substrate surface for covering the entire substrate surface. In contrast hereto, it is suggested herein to apply only very small volumes of such liquid onto partial areas of the substrate surface. Such small volumes may be applied as droplets of sub-microliter or even sub-nanoliter volume or picoliter volume. Such an approach allows selectively covering partial areas of the substrate surface by a thin layer of liquid, i.e. a thin liquid film, while other partial areas of the substrate surface may remain uncovered or may be covered with a different layer of liquid. Accordingly, the entire surface of the substrate may be covered with a patterned layer of liquid. The patterning may have lateral dimensions being significantly smaller than lateral dimensions of the substrate, i.e. for example in a sub-centimeter or even sub-millimeter range. Depending on a spatial resolution of the applied printing technique, such resolution may reach down to e.g. 30 µm or even down to 1 µm. The deposited layer of liquid may subsequently be solidified, thereby forming the dielectric layer on the substrate's surface. After the first layer of the liquid has been solidified, another layer of liquid is deposited on top thereof and is then also solidified, thereby forming a stack of dielectric layers. The method may be used e.g. for preparing laterally patterned one-dimensional photonic crystals by applying multiple patterned dielectric layers on top of each other.

Subsequently, possible features of embodiments of the invention and associated possible advantages will be described in more detail.

The substrate on which the dielectric layer is to be prepared may be any kind of substrate. The substrate may be flexible. For example, the substrate may be a foil. The flexible substrate may have a thickness of e.g. less than 5 mm, less than 1 mm or even less than 0.1 mm. Alternatively, the substrate may be rigid. For example, the substrate may be a plate or rigid sheet or a solid body. For example, the rigid substrate may have a thickness of more than 0.1 mm, more than 1 mm or more than 5 mm. The substrate may comprise or consist of different materials. For example, the substrate may comprise or consist of glass, polymeric material, metal material, semiconductor material, etc.

Depending on initial characteristics of the substrate, particularly material characteristics, the substrate may be pre-processed before submitting the substrates to processing steps of the method described herein. For example, the substrate may be cleaned, plasma-treated and/or surface-etched. Alternatively or additionally, the substrate may be coated with solid material. The coating may for example serve for enhancing adhesion of subsequently applied material, serve for protecting the substrate surface against mechanical and/or chemical influences, act as an intermediate layer for adapting thermal expansion characteristics of the substrate to those of a subsequently applied dielectric layer, etc.

On a surface of the substrate, a layer of liquid is deposited. Therein, the term "liquid" is to be interpreted in a wide manner. Particularly, such term may be interpreted as being flowable. A viscosity of the liquid may be within a large interval ranging from very low viscosities, like in water or another solvent, via medium viscosities, like in oil, to high viscosities, like in a paste.

Particularly, the liquid shall be printable. This means that small volumes included in droplets of the liquid may be selectively deposited on top of the surface of the substrate or on top of a coating or another dielectric layer previously applied to such surface. The droplets have volumes of less than one hundred nanoliters (< 100 nL), preferably less than ten nanoliters (< 10 nL) or less than one nanoliter (< 1 nL), particularly less than 200 picoliters (< 200 pL) or even less than 50 picoliters (< 50 pL) or less than 10 picoliters (< 10 pL). For example, the droplets may have a diameter of less than 0.3 mm, less than 0.1 mm, less than 30 µm, less than 10 µm, less than 3 µm or even less than 1 µm. Accordingly, upon covering the surface of the substrate, such droplets may form a liquid layer having a thickness of for example less than 10 µm, preferably less than 1 µm, less than 500 nm, less than 200 nm or even less than 100 nm. As such layer thickness is in a range of wavelengths of electromagnetic radiation to be affected by the stack of dielectric layers, for example in a range of wavelengths of visible light or of infrared light or of fractions of such light, the liquid layer may induce optical interferences upon being irradiated with such radiation.

The liquid to be printed comprises dielectric constituents. Preferably, the dielectric constituents form a minority of the entire volume of the liquid, i.e. less than 50%, preferably less than 20%, less than 10% or for example between 1% and 5% or between 2% and 4% of the liquid volume is provided by the dielectric constituents. The remainder of the liquid may be formed for example by a solvent and/or by a matrix material. Preferably, the liquid comprises no or at most a negligible amount of optically absorbing constituents. For example, optically absorbing constituents shall preferably form less than 10 %, preferably less than 5%, less than 2% or even less than 1% of the entire liquid volume. In other words, the liquid is highly optically transparent with a transparency of preferably more than 90%, more than 95%, more than 98% or even more than 99%.

The liquid may be printed onto all areas or only partial areas of the surface of the substrate. Accordingly, the layer of liquid may cover the entire substrate surface or only portions thereof. Particularly, the liquid may be printed in separate local areas such as to form patterns. Therein, in some partial areas, droplets are deposited, whereas, in other partial areas, no droplets are deposited. Alternatively, in some partial areas, a first type of droplets is deposited, whereas, in other partial areas, a second type of droplets is deposited, wherein the first and second types of droplets may differ for example with regards to a volume of the droplets, a number of droplets deposited in a same or overlapping area, constituents in the droplets, etc.

Upon having printed the layer of liquid on the surface of the substrate, a dielectric layer is formed by solidifying this liquid layer. As discussed in further detail below, the process of solidifying the liquid layer may be induced in various manners including e.g. drying the liquid by vaporizing solvents, cross-linking polymeric matrix material, annealing or sintering the dielectric constituents, etc. The resulting dielectric layer may be formed with a high degree of homogeneity with regards to layer thickness, layer material composition, layer density, etc. Therein, characteristics of the dielectric layer may be influenced by various parameters including, inter-alia, characteristics of the constituents in the initial liquid, characteristics of the layer of liquid, characteristics of the procedure used for solidifying the liquid layer, etc. Preferably, characteristics are adapted or optimized such that the resulting dielectric layer is provided with desired physical characteristics, particularly with desired optical characteristics such as an intended dielectric layer thickness, refractive index in the dielectric layer, etc.

According to an embodiment, the liquid is printed onto the surface of the substrate using an inkjet printing technique.

Inkjet printing is a technique for recreating digital images by propelling droplets of ink onto a substrate. Various types of inkjet printing techniques have been developed including for example continuous inkjet printing, drop-on-demand printing, etc. Many of these types of inkjet printing techniques may be applied or may be adopted for the method described herein.

Furthermore, various types of inks have been developed for inkjet printing. Conventionally, such inks comprise optically absorbent constituents such as color particles. The constituents may be dissolved in a solvent or may be comprised in a matrix material. For the purposes described herein, such optically absorbent constituents in the ink should be replaced by optically transparent dielectric constituents. However, other characteristics of the constituents such as the particle size of particles forming the constituents, the solvent or the matrix material may be similar to those used in conventional inks. It may be required that the characteristics of the constituents of the ink are specifically adapted and/or optimized for the purpose of generating a layer of liquid having beneficial characteristics in order to finally form the dielectric layer with intended characteristics.

A tool or apparatus used for generating droplets and ejecting the droplets towards a surface to be printed on is generally referred to as printing head. Such printing head generally has one or a plurality of small cavities which may be filled with ink provided from a reservoir. The ink may then be expelled from the cavity via a nozzle due to pressure temporarily generated within the cavity for example using a piezo actuator or a thermal actuator. Generally, printing heads as developed for conventional inkjet printing may be used or may be adapted for printing the liquid layer for eventually forming the dielectric layer as described herein.

According to an embodiment, the layer of liquid is printed by depositing droplets with at least one of varying droplet volumes, varying inter-droplet distances and varying overlapping of neighboring droplets along a lateral extension of the surface of the substrate, such as to form the dielectric layer with locally varying layer thicknesses with lateral dimensions of such locally varying layer thicknesses being smaller than 1 cm, preferably being smaller than 1 mm or even being smaller than 100 µm, smaller than 40 µm or smaller than 10 µm.

In other words, characteristics of the ink droplets and the locations where these ink droplets are deposited on the substrate surface may specifically be selected such that the resulting dielectric layer formed on the substrate surface is not generated homogeneously along the entire lateral extension of the substrate surface. Instead, the resulting dielectric layer may be patterned. In the pattern, the thickness of the dielectric layer varies for different partial areas along the surface of the substrate. For example, in a first partial area, the layer thickness may be more than a predetermined layer thickness limit whereas in a neighboring second partial area, such layer thickness may be smaller or may even be zero (i.e. there is no dielectric layer in this second partial area).

Whether or not a layer of liquid is formed in a partial area and which thickness this liquid layer has is generally influenced by various parameters. Of course, whether or not any droplets are ejected onto a partial area determines whether or not any liquid layer is formed on this partial area. Additionally, the thickness of such a liquid layer may be influenced by the volume each of the droplets has. Furthermore, the inter-droplet distance, i.e. a distance between locations onto which neighboring droplets are ejected, generally influences the thickness of the resulting liquid layer. Furthermore, neighboring droplets may be ejected such that local areas covered by each of the droplets partially or fully overlap. The degree of such overlapping generally also influences the thickness of the resulting liquid layer. Suitably selecting each of these influencing parameters may be used for precisely determining the thickness of the resulting dielectric layer.

As the liquid layer shall be formed by locally depositing small droplets, suitably selecting the parameters of the droplets and of the printing of the droplets may be used for specifically locally determining the layer thickness of the dielectric layer finally formed from the liquid layer. Therein, the technique of printing droplets allows locally providing such layer thicknesses within patterns having lateral dimensions of less than 1 cm or even less than 1 mm. Accordingly, very fine patterns of dielectric materials may be printed onto a substrate surface using the method described herein. Such fine patterns may be beneficially applied for various purposes, some examples of which being further described below.

According to an embodiment, the liquid is printed such that for each location to be covered by the liquid layer, at least two droplets are locally deposited at the location such as to superimpose each other.

Generally, for each location, i.e. for each partial area of the substrate's surface, which finally is to be covered by the dielectric layer, at least one droplet has to be deposited such that its liquid covers the intended location. However, it has been observed that, upon injecting single droplets, variations with regards to the volume of the droplets may occur. Such variations may result in the layer of liquid having varying thicknesses along its lateral extension, as droplets intended for generating the liquid layer at different sites do not have exactly the same volume. As the volume of the single droplets is not exactly controllable, also the variations of the thickness of the liquid layer are not exactly controllable. In order to at least increase controllability, it may therefore be advantageous to, instead of ejecting single droplets at each location, eject two or more droplets for covering the location. Thereby, statistical effects with regards to the droplet volumes may result in the liquid layer being printed with a more homogeneous layer thickness.

According to the invention, the method comprises printing multiple layers of liquid on top of each other thereby forming a layer stack comprising multiple dielectric layers. Expressed differently, the resulting stack of dielectric layers shall be formed by depositing a plurality of layers of liquid, i.e. ten or more layers, sequentially one over the other. Accordingly, a stack of dielectric layers is formed in a consecutive manner. Therein, each dielectric layer may have a small thickness of e.g. below 100 nm, whereas the entire stack may have a larger thickness of e.g. several hundreds or thousands of nanometers, the thickness of the stack corresponding to the sum of the thicknesses of the dielectric layers.

Therein, according to the invention, each of the multiple liquid layers is solidified before printing a subsequent liquid layer.

It has been observed that, as long as the liquid layers printed on top of each other are not solidified, their material may mix. Accordingly, while in general each liquid layer could be printed with different material characteristics and/or layer characteristics, such characteristics may be affected or diluted upon the liquid layer being in contact with another liquid layer. Therefore, it has been found to be advantageous to solidify each printed liquid layer before printing the subsequent liquid layer on top. In fact, for some embodiments as described further below, it has been found to be even indispensable that, before printing a subsequent liquid layer, the preceding liquid layer is solidified. Therein, the step of solidifying shall be adapted such that, inter-alia, excessive mixing of material of adjacent liquid layers is prevented.

According to the invention, the first one of the multiple layers of liquid is printed using a first liquid comprising first dielectric constituents and the second one of the multiple layers of liquid is printed using a second liquid comprising second dielectric constituents being different from the first dielectric constituents.

In other words, while, in principle, it is also possible to apply the presented method for generating a stack of dielectric layers in which each layer is prepared with the same type of liquid and, accordingly, the entire stack has a substantially homogeneous material composition, it may be preferred to generate various dielectric layers in a stack with different dielectric constituents. As the first and second dielectric constituents generally have different physical characteristics, also the physical characteristics of the dielectric layers in the layer stack will vary. Accordingly, the method allows successively printing the dielectric layers of a layer stack with each of the layers contributing individually and with different physical characteristics to the physical characteristics of the entire layer stack.

For example, the optical characteristics of the entire layer stack are influenced by the optical characteristics of each of the dielectric layers comprised in the stack. Therein, each dielectric layer has its individual optical transmission characteristics and its individual effect of optical interferences, both characteristics being influenced, inter-alia, by material properties of the dielectric constituents in the layer as well as by the thickness of the layer.

According to the invention, the multiple first and second layers of liquid are printed alternately on top of each other.

That means, for the resulting stack of dielectric layers, each dielectric layer formed from the first dielectric constituents of a first liquid is interposed between adjacent dielectric layers formed from the second dielectric constituents of a second liquid, and vice versa. Such a stack of alternating first and second dielectric layers may have advantageous physical characteristics. For example, optical characteristics of such a stack may be adapted by suitably selecting the dielectric constituents in the alternating dielectric layers and printing the alternating dielectric layers with suitable thicknesses.

According to the invention, the constituents in the various printable liquids may be selected such that a refractive index of the first dielectric constituent differs from a refractive index of the second constituent by at least 0.1, preferably at least 0.2 or at least 0.3.

Accordingly, the first dielectric layers comprised in the layer stack may mainly consist of material having for example a refractive index of below 1.7, preferably below 1.6, whereas second dielectric layers comprised in the layer stack may mainly consist of material having for example a refractive index of above 1.8 or even above 1.9. Having such different refractive indices in the alternating dielectric layers, the optical characteristics of the entire layer stack may, inter-alia, be tuned for obtaining for example a very high optical reflectance or a very high optical transmission for light irradiated with specific wavelengths. In other words, due to the alternating refractive indices and the specifically selected layer thicknesses in the dielectric layer stack, one-dimensional photonic crystals or dielectric mirrors having enhanced optical properties may be prepared.

Furthermore, according to the invention, upon preparing the multiple layers in the layer stack, the first liquid is adapted such that the second dielectric constituents are soluble in the first liquid at most to a minor extent and/or wherein the second liquid is adapted such that the first dielectric constituents are soluble in the second liquid at most to a minor extent.

In fact, it has been observed that, although a first liquid layer being printed in a preceding cycle is solidified before printing a second liquid layer on top thereof in a subsequent cycle, it cannot be excluded in all cases that first and second dielectric constituents comprised in each layer are prevented from mixing with each other. This may specifically occur when for example a solvent comprised in the subsequently printed second liquid layer is able to at least partially dissolve the material in the already solidified first dielectric layer upon the second liquid layer directly contacting the solidified first dielectric layer. Of course, such dissolving effect and the resulting mixing of first and second dielectric constituents should be prevented at least to a major extent.

Accordingly, the first and second printable liquids should be composed with regards to their dielectric constituents as well as with regards to their other components such as solvents and/or matrix materials such that at most a negligible amount of dielectric constituents comprised in a dielectric layer formed from one of the liquids may be dissolved in the other one of the liquids upon coming into direct contact with each other.

With such specific adaption of the different first and second liquids, dielectric layer stacks may then be prepared with precise and sharp interfaces between the individual dielectric layers. In other words, each individual dielectric layer may have a substantially homogeneous material composition which may significantly differ from a material composition of an adjacent dielectric layer. Therein, a transition between adjacent dielectric layers may be abrupt, i.e. there is preferably no or at most a negligible transition layer in which the first and second dielectric constituents are mixed with each other.

According to an exemplary embodiment, the first liquid comprises titanium dioxide particles as the first dielectric constituents.

Titanium dioxide particles may be prepared easily and at low costs and may be included in a liquid at high densities, thereby forming a printable ink. A printed layer of titanium dioxide generally has a relatively large refractive index of above 1.8 for light with wavelengths in the visible spectral range. Therein, the refractive index of the printed titanium dioxide layer depends on the wavelength and generally increases from for example 1.87 at 780 nm to larger values at shorter wavelengths, for example to 2.08 at 380 nm.

According to a further specified embodiment, the titanium dioxide particles are included in a matrix material which may be solidified by UV irradiation.

The matrix material may for example be a specific polymeric material. For example, there are UV-curable polymeric materials which solidify upon being irradiated with high-energy UV light. Accordingly, the mixture of titanium dioxide particles and matrix material may initially be liquid and may therefore be printable. Upon the liquid layer being printed, the matrix material may be solidified using UV irradiation, thereby forming the solid dielectric layer. Accordingly, a majority of the dielectric layer is formed by the titanium dioxide particles embedded in the matrix material.

According to a further exemplary embodiment, the second liquid comprises poly(methyl methacrylate) (i.e. PMMA) as the second dielectric constituent.

PMMA is known as a high-quality polymeric material having beneficial dielectric characteristics. For example, a refractive index of PMMA is slightly below 1.5 and is essentially constant for all wavelengths in the visible spectral range. Having such a low refractive index, PMMA appears to be a suitable partner dielectric for preparing stacks of dielectric layers. Therein, first dielectric layers including for example titanium dioxide particles with a refractive index of above 1.8 may alternate with second dielectric layers including PMMA with a refractive index of below 1.5. With first and second dielectric layers of such different refractive indices, optical characteristics of the resulting layer stack may be beneficially tuned. For example, very high reflectance values may be obtained with dielectric layer stacks comprising several of the proposed first and second dielectric layers, such reflectance values reaching for example 98% or even more upon stacking for example up to twenty dielectric layers.

According to a further specified embodiment, the poly(methyl methacrylate) is included in a solvent comprising 1,3-dimethoxybenzene.

It has been found that PMMA may be provided in a liquid comprising 1,3-dimethoxybenzene as a solvent, thereby providing a printable ink. After having printed the liquid layer, the layer may for example be solidified by drying the solvent at elevated temperatures and/or reduced pressures in a surrounding atmosphere.

Generally, according to an embodiment, the liquid layer is solidified by applying at least one of several solidification techniques including drying the liquid layer, irradiating the liquid layer using electromagnetic radiation and/or submitting the liquid layer to elevated temperatures of at least 40 °C.

In other words, the printed liquid layer may be solidified by drying its liquid constituents such as solvent and/or matrix material. Therein, the drying process may include evaporating the liquid constituents. The drying procedure may be easily implemented using for example a drying chamber in which a dry atmosphere is generated.

Alternatively or additionally, the printed liquid layer may be solidified by irradiating electromagnetic radiation. The electromagnetic radiation may be absorbed in the liquid constituents, particularly in a liquid matrix material. Energy transferred to the liquid constituents upon such absorption may result in a curing reaction, thereby solidifying the initially liquid constituents. For example, the electromagnetic radiation may be light having wavelengths of less than 380 nm. Absorption of such high-energy electromagnetic radiation may induce UV-curing in specific polymeric materials. The electromagnetic radiation may be generated with relatively simple tools. For example, UV radiation may be emitted by specific lamps.

Further alternatively or additionally, the printed liquid layer may be submitted to elevated temperatures of at least 40°C or at least 50°C or even at least 90°C. Such submission to elevated temperatures may act as a drying process, annealing process, pre-baking process and/or hard-baking process, depending on further processing parameters such as an atmospheric pressure in an environment of the liquid layer, duration of the submission to the elevated temperatures, etc. As a result of such a processing step, the initially liquid layer may be easily and stably solidified. Requirements for tools for establishing such solidification processes may be low as for example a heater or a heating chamber may be sufficient.

It shall be noted that possible features and advantages of embodiments of the invention are described herein partly with respect to a preparation method and partly with respect to liquids, constituents and/or tools used in such method and influencing resulting characteristics of the prepared dielectric layer. One skilled in the art will recognize that the features may be suitably transferred from one embodiment to another and features may be modified, adapted, combined and/or replaced, etc. in order to come to further embodiments of the invention.

### BRIEF DESCRIPTION OF THE DRAWINGS

In the following, advantageous embodiments of the invention will be described with reference to the enclosed drawings. However, neither the drawings nor the description shall be interpreted as limiting the invention.
Fig. 1 visualizes the process step of printing a layer of liquid during a method for preparing a dielectric layer in accordance with an embodiment of the present invention.
Fig. 2 shows a cross-sectional view of a stack of dielectric layers on a substrate prepared in accordance with the method of the present invention.
Fig. 3 shows a top view onto a dielectric layer on a substrate prepared in accordance with the method of the present invention.

The figures are only schematic and not to scale. Same reference signs refer to same or similar features.

### DESCRIPTION OF PREFERRED EMBODIMENTS

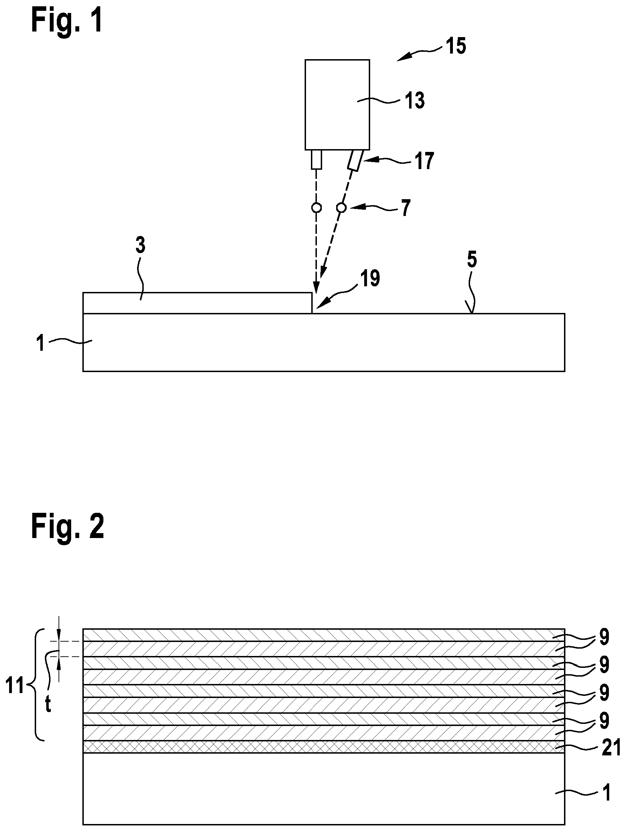

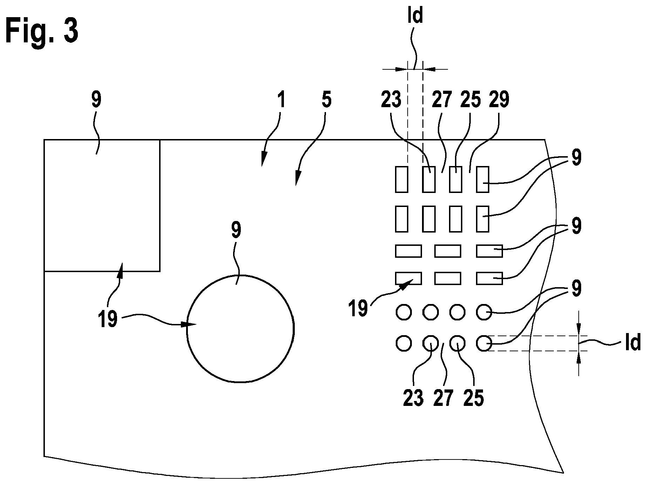

Fig. 1 shows a substrate 1 onto which a dielectric layer is to be prepared. Figs. 2 and 3 show a cross-sectional view and a top view, respectively, of a dielectric layer 9 generated on top of the substrate 1.

The substrate 1 may for example be a flexible foil or a rigid plate. For preparing the dielectric layer 9, a layer 3 of liquid is printed onto a surface 5 of the substrate 1. The liquid comprises dielectric constituents such as PMMA or titanium dioxide particles.

Furthermore, the liquid comprises for example a fluid solvent and/or a fluid matrix material. Fluid properties of the liquid are adapted such that the liquid may form a printable ink. The ink is printed by propelling little droplets 7 from a print head 13 of an inkjet printer 15. The droplets 7 are ejected from the print head 13 via nozzles 17. In the example presented in the Fig. 1, the print head 13 comprises several nozzles 17. Therein, at least two of these nozzles 17 are oriented and directed such that droplets 7 ejected through these nozzles 17 are deposited on a same location 19 on the surface 5 of the substrate 1. By consecutively depositing droplets 7 on the surface 5 of the substrate 1, the layer 3 of liquid is successively generated along the surface 5.

After having prepared such layer 3 of liquid, the liquid is solidified for forming the dielectric layer 9. Various techniques may be applied for such solidification. For example, the liquid may be dried such that substantially all fluid components are evaporated. Alternatively or additionally, for example polymers in the matrix material may be solidified by irradiating UV light, thereby cross-linking and curing the polymers.

Subsequently, another layer 3 of liquid may be deposited on top of the solidified dielectric layer 9. This further layer 3 of liquid may again be solidified for forming another dielectric layer 9. Preferably, the further layer 3 of liquid comprises second dielectric constituents which differ from the first dielectric constituents comprised in the liquid used for the preceding layer 3 of liquid. By repeating such a procedure multiple times, a stack 11 of dielectric layers 9 is generated. This stack 11 comprises an alternating layer sequence of dielectric layers 9 comprising the first dielectric constituents and dielectric layers 9 comprising the second dielectric constituents. Due to the different dielectric constituents, the alternating dielectric layers 9 may be provided with a dielectric material having different refractive indices.

As shown in Fig. 2, the dielectric layers 9 generally have a substantially smaller layer thickness t as compared to the thickness of the substrate 1. Such layer thickness may be in a range of less than 1 µm, typically less than 200 nm. Due to using the inkjet printing technique, the volume of the droplets 7 and the locations 19 where these droplets 7 are deposited may be selected such that the layer thickness may be adapted with a precision of less than 20 nm, preferably less than 5 nm.

In the example shown in figure 2, an additional adhesion layer 21 is deposited on top of the surface 5 of the substrate 1 before printing the first layer 3 of liquid thereon. This adhesion layer 21 may increase adhesion between the material of the substrate 1 and the material of the adjacent dielectric layer 9.

As shown in the top view of Fig. 3, the layer 3 of liquid is not printed along the entire surface 5 of the substrate 1 but only at predetermined locations 19. Accordingly, the resulting dielectric layer 9 covers the surface 5 of the substrate 1 with a pattern. Therein, first partial areas 23 covered by the dielectric layer 9 are separated from neighboring second partial areas 25 also covered by the dielectric layer 9 via intermediate partial areas 27 which are not covered by any dielectric layer 9 such that, in the intermediate partial area, the surface 5 of the substrate 1 is exposed. In other words, while in the first and second partial areas 23, 25, a thickness of the dielectric layer 9 is non-zero, a thickness of the dielectric layer 9 in the intermediate partial area 27 is zero. Lateral dimensions Id of such locally varying layer thicknesses may be smaller than 1 cm or even smaller than 1 mm. Therein, the lateral dimensions Id may correspond to a width of a smallest one of the partial areas 23, 25 and the intermediate partial area 27.

It shall be noted that the terms "first" and "second" are used herein only for distinguishing respective features and shall not be interpreted as necessarily indicating an order or sequence. For example, a "first layer" does not necessarily have to be printed before a "second layer" and the "second layer" does not necessarily have to be printed on top of a "first layer", but the order may also be inverse. Furthermore, it shall be noted that the pattern of dielectric layers 9 shown in Fig. 3 is exemplary only and the locations 19 and shapes of the partial areas 23, 25, 27 are visualized in an arbitrary manner only.

In the following, possible features and advantages of an experimental implementation of the method described herein will be described with reference to a preferred embodiment. Therein, some of the features are described with a slightly different wording as compared to the preceding sections.

One-dimensional photonic crystals (1DPCs) have been widely investigated since the last century due to their fascinating capability of optical manipulation and structural coloration. A 1DPC has a structure where the refractive index (RI) is periodically distributed along one dimension in space, which can be built by alternating two materials with different RI or tuning the porosity of one material. Due to the multilayer interference effect, 1DPCs possess a photonic bandgap (PBG) analogous to the electronic bandgap in semiconductors. Electromagnetic waves at specific frequencies cannot propagate inside these media. By tailoring the stacking sequence, layer thickness, and material composition, it is possible to tune the photonic stopband to meet almost any desired characteristic, e.g. wavelength-selective filters and ultra-high reflectivity dielectric mirrors. Dielectric laser mirrors and dichroic beamsplitters are essential discrete elements of different optical systems. In many integrated optical components and systems, 1DPCs are used as distributed Bragg reflectors (DBR). Furthermore, 1DPCs enable highly sensitive optical sensors and colorful coatings for solar cells. Various materials have been used to fabricate 1DPCs, including inorganic, organic and hybrid materials. Different fabrication methods have been applied to manufacture 1DPCs: Physical vapor deposition (PVD) and chemical vapor deposition (CVD) are widely used in industry. CVD-based dielectric mirrors are used for realizing vertical-cavity surface-emitting lasers (VCSELs). This technology, however, is very specialized and time-consuming. What's more, both methods need to be combined with lithographic patterning to obtain lateral structures. More recently, solution-based processes such as spin coating, dip coating, doctor blading, and self-assembly have emerged as attractive methods. As for spin coating, the drawbacks are the high material waste, limitations on substrate size, and the defects on thin film such as striations and comets which lead to poor stack quality. Doctor blading and self-assembly, on the other hand, can be used for large-scale production; however, it is very challenging to land with a good reproducibility on the layer thickness and good control on the thin film quality. Moreover, the lateral definition of 1DPC pixels is not possible with any of the abovementioned approaches.

A fully digitally fabricated 1DPCs prepared by inkjet printing is reported herein. Therein, a high RI contrast hybrid material pair based on printable nanoparticulate titanium dioxide (TiO₂) and poly(methyl methacrylate) (PMMA) is used as inks. With ten bilayers, a maximum reflectance of around 99% was achieved, while a reflectance peak of more than 80% can be reached with five bilayers only. The central wavelength can be tuned in the spectrum from purple, through the whole visible range of the electromagnetic spectrum, into the infrared region by simply changing the layer thickness via modifying the printing parameters. Furthermore, not only small 1DPCs on rigid glass substrates were fabricated, but also large and patterned 1DPCs were successfully built on flexible foils. Inkjet printing, a simple, fast, and low-cost technique, therefore enables the fabrication of 1DPCs in various forms in different optoelectronic devices. Hence, it offers a pathway towards either up-scaling in macroscopic scale, such as a colorful patterned coating for solar cells, or pixelwise in integrated photonics applications, such as a spectrometer with high spatial and spectral resolutions.

A Bragg mirror is a device based on 1DPC. Therein, a central wavelength of the photonic bandgap generally only depends on an optical thickness of a first dielectric layer (H) having a high refractive index and a second dielectric layer (L) having a low refractive index. Hence, it can be tuned by changing the material composition and even simpler by the layer thickness. With the same constituent materials, the maximum reflectance is only influenced by the number of layers, and a higher reflectance can be obtained by stacking more layers.

In principle, the layer thickness can be controlled in an inkjet printing process by modifying the printing parameters. However, key challenges are the nanometer control of the thickness, the uniformity of the printed layers, and the choice of solvents such that intermixing of L and H layers is avoided.

Here, TiO₂ and PMMA were chosen as the constituent materials due to their widespread usage in optical applications and their high contrast in RI. The fabrication process of 1DPCs was completed by alternately printing the PMMA and Ti0₂ layers on each other, as illustrated in Figure 2. In order to be applied as suitable inks for the inkjet printing process, Ti0₂ nanoparticle dispersion with a UV curable organic matrix and PMMA ink were developed. At room temperature, PMMA showed a very low solubility in the solvent used for TiO₂ ink. Therefore, it ensures that the previously printed PMMA layer would not be dissolved during the next TiO₂ printing step. The RI of both materials were measured by ellipsometry. The RI of a printed TiO₂ layer is 2.08 at 380 nm and 1.87 at 780 nm, while at these wavelengths, the RI of a PMMA layer is 1.49 and 1.48, respectively. This gives a high RI contrast ranging from 0.59 to 0.39 in the visible light range and renders these materials suitable to be used as high index and low index layers in the Bragg stack. In order to have different spectra with central wavelength over the whole visible light range, the thickness of each layer was adjusted by changing the printing resolution, i.e. the deposition volume per unit area. During printing, at least ten nozzles were used for jetting, and the quality factor was chosen as 2, which means one vertical line will be printed by two nozzles. By these means, the variation in individual droplet volume was minimized in each printing round. After printing the TiO₂ layer, it was first dried at ambient temperature for 2 min, prebaked at 100 °C for 5 min, and then followed by a UV curing step, which is necessary to harden the film. At the same time, the UV-curable polymer matrix (PM) helped to enhance the stability of the TiO₂ layer without the need for a high sintering temperature. After the UV exposure, the TiO₂ film was further hard-baked at 100 °C for 10 min. The UV curing step is an essential process, and an intermixing of the subsequent PMMA layer with TiO₂ layer was observed when the UV radiation dose was not sufficient during exposure. As for the PMMA layer, it was first dried in a vacuum chamber at 10 mbar for 2 min and then heated at 50 °C for 5 min to eliminate the solvent residuals.

In order to realize a highly reflective mirror, a larger number of bilayers has to be deposited on top of each other. For achieving a reflectance of more than 98%, ten bilayers are needed by calculations. Fig. 2 shows a cross-sectional view of an exemplary 1DPC with several bilayers, the view substantially representing a cross-sectional scanning electron microscopy (SEM) of an actual printed 1DPC with ten bilayers. The bottom PMMA layer was intentionally designed to have a relatively larger thickness to ensure a closed PMMA film on the substrate. Meanwhile, this has little impact on the final optical property of the 1DPC due to its similar RI as the substrate. From the multilayer structure, it can be clearly seen that the thickness of each layer is uniform over a large area. Furthermore, the repeatability of the printing process is evident from the constant layer thickness of the same material. The inkjet printing may result in a closed Ti0₂ film with densely packed nanoparticles embedded in a polymer matrix. Measured reflectance and transmittance spectra of fabricated 10-bilayer 1DPCs show their excellent reflection/dichroic behavior with different central wavelengths. A maximum reflectance of about 99% was achieved, while the highest reflectance in the other 1DPCs reached around 98%.

The good complementary between the reflectance and transmittance spectra validates the peak values and also indicates that there is neither absorption nor optical scattering in the materials in the visible light range. The bandwidth of the PBG becomes larger with increasing central wavelength, as predicted by mathematical calculation. In addition, the 1DPC with a central wavelength at 416 nm shows a significant drop in transmittance near/in the ultraviolet light range due to the light absorption in both constituent materials and the glass substrate.

The prepared inkjet-printed 1DPCs can not only be used as high reflectivity mirrors but also as dichroic beamsplitters.

After the inks have been developed, the inkjet printing process can be transferred to a large variety of substrates. Only the printing parameters for the first PMMA layer need to be adjusted according to the wettability of the substrate. Therefore, 1DPCs can be printed not only on small and rigid substrates but also in specific patterns on large and flexible substrates. Hence, 1DPCs were also printed on 12 x 12 cm² polyester (PET) foils. The deformability of the printed 1DPCs, therefore, allows for their applications on curved surfaces with a high degree of freedom. The excellent color homogeneity over a large area and the high reflectance give the inkjet-printed 1DPCs a massive potential for a large variety of applications.

### Exemplary substrate preparation

A 2.5 x 2.5 cm² glass substrates (soda lime glass) and 12 x 12 cm² PET foils (Puetz Folien) were cleaned in an ultrasonic bath in deionized water, acetone, and isopropanol for 10 min each. Then the substrates were treated by oxygen plasma in a plasma chamber (PlasmaFlecto 30, Plasma technology) with a power of 100 W for 10 min.

### Exemplary ink preparation and inkjet printing

PMMA with a molecular weight of 65000 Da (PSS-polymer) was dissolved in 1,3-dimethoxybenzene (≥98%, Sigma-Aldrich) to achieve a concentration of 40 mg/ml, and 10% hexylbenzene (97%, Sigma-Aldrich) was added to mitigate the coffee ring effect. Ti0₂ ink was prepared by diluting the TiO₂ nanoparticle dispersion (RF-IO-UV, Avantamar) with ethylene glycol monopropyl ether (99.4%, Sigma-Aldrich) to reach a final concentration of 3.8 wt.%. The concentrations of the inks were determined to reach the target thickness range with suitable printing parameters. Before printing, both inks were placed in an ultrasonic bath for 5 min and then filtered using PTFE filters with a pore size of 0.2 µm. The inkjet printer (PixDro LP50) was equipped with 10 pL cartridges (Fujifilm Dimatix). During printing, at least 10 nozzles were used for jetting. The substrate temperature was set at 24 °C. The print head temperature was set at 27 °C and 28 °C for TiO₂ and PMMA ink, respectively. The waveforms were custom-made for up to 2.5 kHz jetting frequency. Both waveforms were simple single peak waveforms with a maximum voltage of 22 V, because the inks have been developed to be in the most suitable range for inkjet printing. First, a PMMA layer was printed directly on the substrate, and then the layer was vacuum dried at 10 mbar for 2 min and then placed on a hotplate at 50 °C for 5 min. TiO₂ layer was subsequently printed on top of the PMMA layer, and this layer was first dried at ambient temperature for 2 min, and then pre-baked on a hotplate at 100 °C for 5 min, UV-cured for 10 min with a UV-LED light source (GC 77, Hamamatsu), and subsequently post-baked at 100 °C for 10 min. The following PMMA and TiO₂ layers were alternately printed and processed in the same way. The thickness of each layer was controlled by changing the printing resolution, which determines how much volume is finally deposited on a unit area. The printing resolutions were in the range of 550 to 900 dpi for Ti0₂ ink and 500 to 700 dpi for PMMA ink. The whole fabrication process was completed in a cleanroom with the environment temperature at 21-22 °C and humidity at 40-50%.

In conclusion, the first fully digitally manufactured 1DPCs by multilayer inkjet printing has been demonstrated. The central wavelength can be tuned from the purple to infrared spectral range, i.e. from 416 nm to 808 nm. The central wavelength was tuned by changing the printed layer thickness, and the maximum reflectance was adjusted by controlling the number of bilayers. The reflectance peak reached up to around 99% when ten bilayers were printed. Without the need for a high sintering temperature, 1DPCs were successfully printed on glass substrates as well as on flexible PET foils in designed patterns. The printed 1DPCs showed a good color homogeneity and an overall high quality in optical property, making inkjet printing a highly competitive candidate for the large-scale fabrication of high-quality 1 DPCs. Inkjet printing offers a fast, simple, material-saving, and low-cost fabrication route. Inkjet-printed 1DPCs, large or small, patterned or unpatterned, can be used in numerous different fields, as functional and decorative optical components. Vast applications may be foreseen, ranging from additive manufacturing of integrated photonic systems (e.g., in sensing systems) to large-area applications such as aesthetically appealing photovoltaics.

Finally, it should be noted that the term "comprising" does not exclude other elements or steps and the "a" or "an" does not exclude a plurality. Also elements described in association with different embodiments may be combined. It should also be noted that reference signs in the claims should not be construed as limiting the scope of the claims.

### LIST OF REFERENCE SIGNS

- 1: substrate
- 3: layer of liquid
- 5: surface of the substrate
- 7: droplet
- 9: dielectric layer
- 11: stack
- 13: print head
- 15: inkjet printer
- 17: nozzle
- 19: location
- 21: adhesion layer
- 23: first partial area
- 25: second partial area
- 27: intermediate partial area

- t: layer thickness
- Id: lateral dimension

## Claims

1. Method for preparing a stack (11) of dielectric layers (9) forming a one-dimensional photonic crystal on a substrate (1), wherein the method comprises:
- providing the substrate (1),
- printing a first layer (3) of liquid onto a surface (5) of the substrate (1) using a first liquid comprising first dielectric constituents and having an optical transparency of more than 90%,
- forming a first dielectric layer (9) by solidifying the first layer (3) of liquid,
- printing a second layer (3) of liquid onto the first dielectric layer (9) using a second liquid comprising second dielectric constituents being different from the first dielectric constituents and having an optical transparency of more than 90%,
- forming a second dielectric layer (9) by solidifying the second layer (3) of liquid, wherein multiple first and second layers (3) of liquid are printed alternately on top of each other thereby forming the layer stack (11) comprising multiple dielectric layers (9), wherein each of the multiple first and second layers (3) of liquid is solidified before printing a subsequent liquid layer (3),
wherein ten or more bilayers each including a first and a second dielectric layer (9) are sequentially formed one over the other,
wherein a refractive index of the first dielectric constituent differs from a refractive index of the second dielectric constituent by at least 0.1, and
wherein the first liquid is adapted such that the second dielectric constituents are soluble in the first liquid at most to a negligible extent and/or wherein the second liquid is adapted such that the first dielectric constituents are soluble in the second liquid at most to a negligible extent,
wherein the liquid is printed such that droplets (7) having a volume of less than one hundred nanoliters are locally deposited per square millimeter on the surface (5) of the substrate (1).

2. Method according to claim 1,
wherein the liquid is printed onto the surface (5) of the substrate (1) using an inkjet printing technique.

3. Method according to one of the preceding claims,
wherein the layer (3) of liquid is printed by depositing droplets (7) with at least one of varying droplet volumes, varying inter-droplet distances and varying overlapping of neighboring droplets (7) along a lateral extension of the surface (5) of the substrate (1), such as to form the dielectric layer (9) with locally varying layer thicknesses (t) with lateral dimensions (Id) of such locally varying layer thicknesses (t) being smaller than 1 cm, preferably being smaller than 1 mm.

4. Method according to one of the preceding claims,
wherein the liquid is printed such that for each location (19) to be covered by the liquid layer (3), at least two droplets (7) are locally deposited at the location (19) such as to superimpose each other.

5. Method according to one of claims 1 to 4,
wherein the first liquid comprises titanium dioxide particles as the first dielectric constituents.

6. Method according to claim 5,
wherein the titanium dioxide particles are included in a matrix material which may be solidified by UV irradiation.

7. Method according to one of claims 1 to 6,
wherein the second liquid comprises poly(methyl methacrylate) as the second dielectric constituents.

8. Method according to claim 7,
wherein the poly(methyl methacrylate) is included in a solvent comprising 1,3-dimethoxybenzene.

9. Method according to one of the preceding claims,
wherein the liquid layers (3) are solidified by applying at least one of drying the liquid layer (3), irradiating the liquid layer (3) using electromagnetic radiation and submitting the liquid layer to elevated temperatures of at least 40°C.

10. The method according to claim 1,
wherein the first and/or second layers are printed so as to form a liquid layer having a thickness of less than 10 µm.

11. The method according to claim 1, wherein the first and/or second layers are printed so as to form a liquid layer having a thickness of less than 1 µm.

12. The method according to claim 1, wherein the first and/or second layers are printed so as to form a liquid layer having a thickness of less than 200 nm.

## Patentansprüche

1. Verfahren zur Herstellung eines Stapels (11) von dielektrischen Schichten (9), die einen eindimensionalen photonischen Kristall auf einem Substrat (1) bilden, wobei das Verfahren umfasst:
- Bereitstellen des Substrats (1),
- Drucken einer ersten Flüssigkeitsschicht (3) auf eine Oberfläche (5) des Substrats (1) unter Verwendung einer ersten Flüssigkeit, die erste dielektrische Bestandteile umfasst und eine optische Transparenz von mehr als 90 % aufweist,
- Bilden einer ersten dielektrischen Schicht (9) durch Verfestigen der ersten Flüssigkeitsschicht (3),
- Drucken einer zweiten Flüssigkeitsschicht (3) auf die erste dielektrische Schicht (9) unter Verwendung einer zweiten Flüssigkeit, die zweite dielektrische Bestandteile umfasst, die sich von den ersten dielektrischen Bestandteilen unterscheiden und eine optische Transparenz von mehr als 90 % aufweisen,
- Bilden einer zweiten dielektrischen Schicht (9) durch Verfestigen der zweiten Flüssigkeitsschicht (3),
wobei mehrere erste und zweite Flüssigkeitsschichten (3) abwechselnd aufeinander gedruckt werden, wodurch der Schichtstapel (11) gebildet wird, der mehrere dielektrische Schichten (9) umfasst, wobei jede der mehreren ersten und zweiten Flüssigkeitsschichten (3) vor dem Drucken einer nachfolgenden Flüssigkeitsschicht (3) verfestigt wird,
wobei zehn oder mehr Doppelschichten, die jeweils eine erste und eine zweite dielektrische Schicht (9) enthalten, nacheinander übereinander gebildet werden, wobei sich ein Brechungsindex des ersten dielektrischen Bestandteils von einem Brechungsindex des zweiten dielektrischen Bestandteils um mindestens 0,1 unterscheidet, und
wobei die erste Flüssigkeit so angepasst ist, dass die zweiten dielektrischen Bestandteile in der ersten Flüssigkeit höchstens in einem vernachlässigbaren Ausmaß löslich sind, und/oder wobei die zweite Flüssigkeit so angepasst ist, dass die ersten dielektrischen Bestandteile in der zweiten Flüssigkeit höchstens in einem vernachlässigbaren Ausmaß löslich sind,
wobei die Flüssigkeit so gedruckt wird, dass Tröpfchen (7) mit einem Volumen von weniger als einhundert Nanolitern pro Quadratmillimeter lokal auf der Oberfläche (5) des Substrats (1) abgeschieden werden.

2. Verfahren nach Anspruch 1,
wobei die Flüssigkeit unter Verwendung einer Tintenstrahldrucktechnik auf die Oberfläche (5) des Substrats (1) gedruckt wird.

3. Verfahren nach einem der vorhergehenden Ansprüche,
wobei die Flüssigkeitsschicht (3) durch Abscheiden von Tröpfchen (7) mit mindestens einem von variierenden Tröpfchenvolumina, variierenden Zwischentröpfchenabständen und variierender Überlappung benachbarter Tröpfchen (7) entlang einer lateralen Ausdehnung der Oberfläche (5) des Substrats (1) gedruckt wird, um die dielektrische Schicht (9) mit lokal variierenden Schichtdicken (t) zu bilden, wobei laterale Abmessungen (ld) solcher lokal variierenden Schichtdicken (t) kleiner als 1 cm, vorzugsweise kleiner als 1 mm sind.

4. Verfahren nach einem der vorhergehenden Ansprüche,
wobei die Flüssigkeit so gedruckt wird, dass für jede Stelle (19), die von der Flüssigkeitsschicht (3) bedeckt werden soll, mindestens zwei Tröpfchen (7) lokal an der Stelle (19) abgeschieden werden, um einander zu überlagern.

5. Verfahren nach einem der Ansprüche 1 bis 4,
wobei die erste Flüssigkeit Titandioxidpartikel als die ersten dielektrischen Bestandteile umfasst.

6. Verfahren nach Anspruch 5,
wobei die Titandioxidpartikel in einem Matrixmaterial enthalten sind, das durch UV-Bestrahlung verfestigt werden kann.

7. Verfahren nach einem der Ansprüche 1 bis 6,
wobei die zweite Flüssigkeit Poly(methylmethacrylat) als die zweiten dielektrischen Bestandteile umfasst.

8. Verfahren nach Anspruch 7,
wobei das Poly(methylmethacrylat) in einem Lösungsmittel enthalten ist, das 1,3-Dimethoxybenzol umfasst.

9. Verfahren nach einem der vorhergehenden Ansprüche,
wobei die Flüssigkeitsschichten (3) durch Anwenden von mindestens einem von Trocknen der Flüssigkeitsschicht (3), Bestrahlen der Flüssigkeitsschicht (3) unter Verwendung elektromagnetischer Strahlung und Aussetzen der Flüssigkeitsschicht erhöhten Temperaturen von mindestens 40 °C verfestigt werden.

10. Verfahren nach Anspruch 1,
wobei die ersten und/oder zweiten Schichten gedruckt werden, um eine Flüssigkeitsschicht mit einer Dicke von weniger als 10 µm zu bilden.

11. Verfahren nach Anspruch 1, wobei die ersten und/oder zweiten Schichten gedruckt werden, um eine Flüssigkeitsschicht mit einer Dicke von weniger als 1 µm zu bilden.

12. Verfahren nach Anspruch 1, wobei die ersten und/oder zweiten Schichten gedruckt werden, um eine Flüssigkeitsschicht mit einer Dicke von weniger als 200 nm zu bilden.

## Revendications

1. Procédé de préparation d'un empilement (11) de couches diélectriques (9) formant un cristal photonique unidimensionnel sur un substrat (1), dans lequel le procédé comprend :
- la fourniture du substrat (1),
- l'impression d'une première couche (3) de liquide sur une surface (5) du substrat (1) en utilisant un premier liquide comprenant des premiers constituants diélectriques et ayant une transparence optique supérieure à 90 %,
- la formation d'une première couche diélectrique (9) par solidification de la première couche (3) de liquide,
- l'impression d'une deuxième couche (3) de liquide sur la première couche diélectrique (9) en utilisant un deuxième liquide comprenant des deuxièmes constituants diélectriques qui sont différents des premiers constituants diélectriques et ayant une transparence optique supérieure à 90 %,
- la formation d'une deuxième couche diélectrique (9) par solidification de la deuxième couche (3) de liquide,
dans lequel de multiples première et deuxième couches (3) de liquide sont imprimées en alternance l'une sur l'autre en formant ainsi l'empilement de couches (11) comprenant de multiples couches diélectriques (9), dans lequel chacune des multiples première et deuxième couches (3) de liquide est solidifiée avant l'impression d'une couche de liquide suivante (3),
dans lequel dix bicouches ou plus comprenant chacune une première et une deuxième couche diélectrique (9) sont formées séquentiellement l'une sur l'autre, dans lequel un indice de réfraction du premier constituant diélectrique diffère d'un indice de réfraction du deuxième constituant diélectrique d'au moins 0,1, et dans lequel le premier liquide est adapté de sorte que les deuxièmes constituants diélectriques sont solubles dans le premier liquide au plus dans une mesure négligeable et/ou dans lequel le deuxième liquide est adapté de sorte que les premiers constituants diélectriques sont solubles dans le deuxième liquide au plus dans une mesure négligeable,
dans lequel le liquide est imprimé de sorte que des gouttelettes (7) ayant un volume inférieur à cent nanolitres sont déposées localement par millimètre carré sur la surface (5) du substrat (1).

2. Procédé selon la revendication 1,
dans lequel le liquide est imprimé sur la surface (5) du substrat (1) en utilisant une technique d'impression à jet d'encre.

3. Procédé selon l'une des revendications précédentes,
dans lequel la couche (3) de liquide est imprimée en déposant des gouttelettes (7) avec au moins l'un parmi des volumes de gouttelettes variables, des distances inter-gouttelettes variables et un chevauchement variable de gouttelettes voisines (7) le long d'une extension latérale de la surface (5) du substrat (1), de sorte à former la couche diélectrique (9) avec des épaisseurs de couche (t) variables localement avec des dimensions latérales (ld) de telles épaisseurs de couche (t) variables localement étant inférieures à 1 cm, de préférence inférieures à 1 mm.

4. Procédé selon l'une des revendications précédentes,
dans lequel le liquide est imprimé de sorte que pour chaque emplacement (19) devant être recouvert par la couche de liquide (3), au moins deux gouttelettes (7) sont déposées localement au niveau de l'emplacement (19) de sorte à se superposer l'une à l'autre.

5. Procédé selon l'une des revendications 1 à 4,
dans lequel le premier liquide comprend des particules de dioxyde de titane en tant que premiers constituants diélectriques.

6. Procédé selon la revendication 5,
dans lequel les particules de dioxyde de titane sont incluses dans un matériau de matrice qui peut être solidifié par irradiation UV.

7. Procédé selon l'une des revendications 1 à 6,
dans lequel le deuxième liquide comprend du poly(méthacrylate de méthyle) en tant que deuxièmes constituants diélectriques.

8. Procédé selon la revendication 7,
dans lequel le poly(méthacrylate de méthyle) est inclus dans un solvant comprenant du 1,3-diméthoxybenzène.

9. Procédé selon l'une des revendications précédentes,
dans lequel les couches de liquide (3) sont solidifiées en appliquant au moins l'un parmi le séchage de la couche de liquide (3), l'irradiation de la couche de liquide (3) en utilisant un rayonnement électromagnétique et la soumission de la couche de liquide à des températures élevées d'au moins 40 °C.

10. Procédé selon la revendication 1,
dans lequel les première et/ou deuxième couches sont imprimées de manière à former une couche de liquide ayant une épaisseur inférieure à 10 µm.

11. Procédé selon la revendication 1, dans lequel les première et/ou deuxième couches sont imprimées de manière à former une couche de liquide ayant une épaisseur inférieure à 1 µm.

12. Procédé selon la revendication 1, dans lequel les première et/ou deuxième couches sont imprimées de manière à former une couche de liquide ayant une épaisseur inférieure à 200 nm.
